# EUROPEAN PATENT SPECIFICATION

(11) **EP 0 956 586 B1**
(45) Date of publication and mention of the grant of the patent: **01.03.2006**
(21) Application number: 96940210.6
(22) Date of filing: 20.11.1996
(51) Int. Cl.: H01L 21/316, H01L 21/322, H01L 21/328

(54) **METHOD IN THE MANUFACTURING OF A SEMICONDUCTOR DEVICE**
HERSTELLUNGSVERFAHREN FÜR HALBLEITERANORDNUNG
PROCEDE DE FABRICATION D'UN DISPOSITIF A SEMI-CONDUCTEUR

(30) Priority: 20.11.1995 SE 9504150
(43) Date of publication of application: 17.11.1999
(73) Proprietor: Infineon Technologies AG, 81669 München (DE)
(72) Inventor: NORSTRÖM, Hans, S-171 93 Solna (SE)
(74) Representative: Karlsson, Leif Karl Gunnar
(86) International application number: PCT/SE1996/001511
(87) International publication number: WO 1997/019465

(56) References cited:
- EP-A- 0 573 823
- US-A- 4 792 501
- US-A- 4 960 719
- US-A- 4 988 632
- US-A- 5 213 989
- US-A- 5 266 504
- APPL. PHYS. LETT., Volume 58, No. 15, April 1991, S.J. JENG et al., "Structure, Properties and Thermal Stability of in Situ Phosphorus-Doped Hydrogenated Microcrystalline Silicon Prepared by Plasma-Enhanced Chemical Vapor Deposition", pages 1632-1634.
- IDEM TECHNICAL DIGEST/INTERNATIONAL ELECTRON DEVICES MEETING, 1980, T.H. NING et al., "Self-Aligned NPN Bipolar Transistors", pages 823-824.

## Description

### FIELD OF INVENTION

The present invention relates to a method of etching selectively when manufacturing semiconductor devices and to a method of manufacturing bipolar transistors while applying the selective etching method.

### DESCRIPTION OF THE PRIOR ART

The trend in the design and manufacture of integrated circuits leans towards progressively smaller individual components of progressively higher performances. For instance, the dimensions of bipolar transistors are becoming progressively smaller, both horizontally and vertically, so as to increase packing densities and transistor speeds. Manufacturing precision has therewith become progressively more important, both with regard to individual process stages and with regard to the alignment between different layers.

There is normally used at present in the manufacture of bipolar high frequency transistors a technique that employs a self-registered base-emitter structure (T. H. Ning et al, "Self-Aligned npn Bipolar Transistors", IEDM Techn. Dig., pages 823-824, 1980), which enables the transistor cell to be made smaller while obtaining a reduced base-collector capacitance and a reduced base resistance when the extrinsic base is connected to the intrinsic base in the immediate proximity of the emitter. Several variants of this method are known to the art.

U.S. Patent 5,266,504 describes a method of manufacturing a self-registered bipolar transistor in which the base is grown epitaxially and the emitter is formed by the deposition of an amorphous silicon layer followed by a polycrystalline silicon layer, whereafter the structure is patterned and etched. The amorphous silicon layer is then recrystallized by SPE (Solid Phase Epitaxy). This method is able to provide a thin base and a sharp and well-controlled emitter-base junction.

U.S. 4,988,632 teaches the deposition of a polycrystalline silicon layer or an amorphous silicon layer on a substrate and doping of the layer. A layer of LTO (Low Temperature Oxide) or some other dielectric is deposited on said silicon layer, whereafter the structure is patterned and etched to provide a base electrode and emitter opening. U.S. 5,213,989 teaches a method of depositing a polycrystalline silicon layer, an amorphous silicon layer or some similar silicon-based layer on a substrate and doping said layer, whereafter a dielectric layer, preferably a TEOS-based (Tetra Ethyl Ortho Silicate-based) oxide is deposited over the silicon layer. The structure is patterned and etched in a known manner. It is not evident from U.S. 4,988,632 and U.S. 5,213,989 that the silicon layers shall be amorphous when etching out the emitter openings.

Those problems that occur when selectively etching away a polycrystalline silicon layer from a silicon substrate involve difficulties in stopping the etching process so that the polycrystalline silicon layer is removed completely without penetrating the substrate too deeply. The polycrystalline silicon layer is also etched at different speeds along different crystal directions and at grain boundaries, resulting in etching residues, so-called pillars, or in irregularities in the etched surface, so-called facets, and in blunt or dull edges in the etched openings. When the polycrystalline layer is to be doped by ion implantation, there is a risk of channelization of the dopant in grain boundaries or along crystal directions, meaning that the degree of doping cannot be controlled. Particularly when etching out the emitter opening in the manufacture of bipolar transistors that have a self-registered base-emitter structure, it is of the greatest importance that the aforesaid problems are overcome, since when the substrate is etched too deeply there is a risk of obtaining an excessively high series resistance or no electrical contact at all between intrinsic and extrinsic base. When doping to achieve a given type of doping, n or p, to form the emitter, there is also the risk of forming so-called pipes, i.e. channels of said doping type transversely through the intrinsic base, resulting in emitter leakage. These pipes are formed generally as a result of etching residues, so-called pillars.

### SUMMARY OF THE INVENTION

The object of the present invention is to resolve the aforesaid problems and thus produce semiconductor components, particularly bipolar transistors, of higher quality and/or higher performance and/or of smaller size than those semiconductor components produced by hitherto known methods.

To this end, the inventive method includes the etching of amorphous silicon. Such silicon lacks crystal structures. The use of amorphous silicon thus removes many of the problems and drawbacks encountered when etching polycrystalline silicon.

The inventive method involves depositing an amorphous silicon layer on a crystalline silicon substrate. According to the invention, there is deposited on the amorphous silicon layer a protective dielectric layer without causing crystallization of the amorphous layer. The dielectric layer is deposited by one of the following methods: PECVD (Plasma Enhanced Chemical Vapor Deposition), SACVD (Sub Atmospheric Chemical Vapor Deposition), MBE (Molecular Beam Epitaxy) or with the aid of a spin-on technique. The dielectric layer is preferably comprised of PETEOS (Plasma Enhanced Tetra Ethyl Ortho Silicate). The resultant structure is patterned, and the dielectric layer and the amorphous silicon layer are etched, for instance dry-etched, within a predetermined area.

The inventive etching method provides structures which have sharply defined edges and smooth pronounced etched surfaces in the absence of pillar or facet formation tendencies. Good etching selectivity between amorphous and crystalline silicon is also obtained. This results in semiconductor components of improved performance in relation to earlier semiconductor components. Particularly when fabricating a bipolar transistor having a self-registered base-emitter structure, the aforesaid etching process can be applied when etching-away the emitter opening in a manner which enables semiconductor devices of very small dimensions (length scales in the sub-micrometer range) to be produced. The advantages afforded by the present method include good etching selectivity when etching amorphous silicon on crystalline silicon, good CD control (Critical Dimension control), i.e. good control of the dimensions of the etched opening, and the avoidance of the risk of channelization of the dopant in the case of ion implantation processes.

### BRIEF DESCRIPTION OF THE DRAWINGS

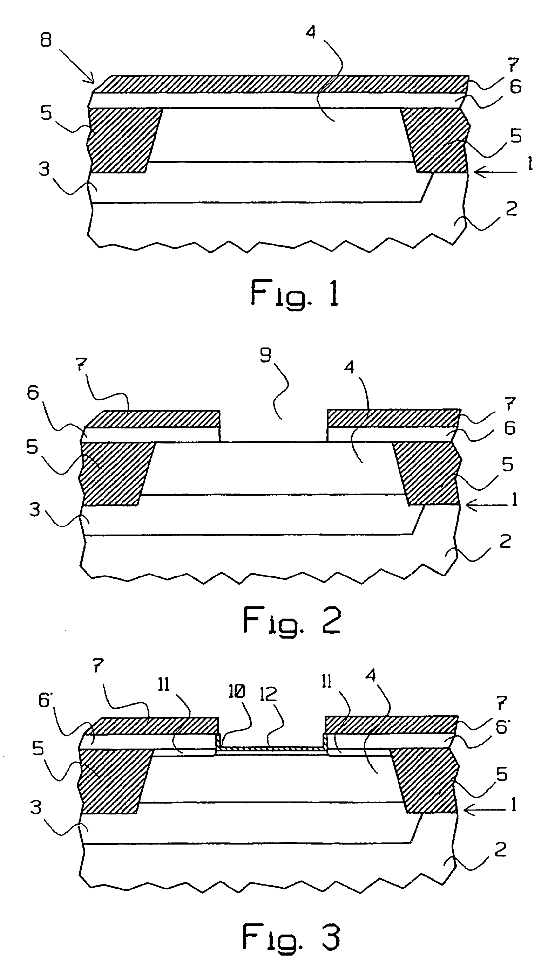

The invention will now be described in more detail with reference to the accompanying drawings, in which Figs. 1-2 are cross-sectional views which illustrate two inventive method steps when etching a silicon layer on a silicon surface, and Figs. 3-6 are cross-sectional views illustrating four inventive method steps in the fabrication of a bipolar transistor having a self-registered base-emitter structure departing from the structure illustrated in Fig. 2.

### DESCRIPTION OF PREFERRED EMBODIMENTS

Shown in Fig. 1 is a silicon substrate 1, wherein the silicon may be a monocrystalline, a polycrystalline or a microcrystalline silicon, but which is preferably a monocrystalline silicon. As in the Fig. 1 illustration, the substrate 1 may have various defined active regions 2-5, which will be described below in more detail, although the substrate may also be homogenous. Any surface oxide present on the substrate 1, said surface oxide possibly having a thickness of some tens of Ångströms, can be removed by conveniently dipping the substrate in an HF bath or in HF vapour. In accordance with the invention, there is deposited on the substrate 1 a layer 6 of amorphous silicon, so-called α-Si to a thickness of some hundred nanometers, preferably with the aid of CVD technique (Chemical Vapor Deposition) at 550-560°C. The amorphous silicon may alternatively be deposited at another temperature and/or with the aid of some other technique, such as PECVD or sputtering. In accordance with the invention, there is deposited on the amorphous silicon layer 6 a protective dielectric layer 7 without causing crystallization of the amorphous layer 6. This is ensured when the dielectric layer 7 is deposited at a temperature below about 500°C and over a relatively short period of time. The so-called single wafer technique is used in this regard, i.e. a technique in which one wafer is processed at a time, which gives shorter deposition times. Such techniques are PECVD, SACVD, MBE and the spin-on technique. The dielectric layer 7 may comprise of a nitride or an oxide for instance, although it will preferably comprise a silicate. The silicate used will conveniently be PETEOS, i.e. TEOS (Tetra Ethyl Ortho Silicate), which is deposited with PECVD. This results in a high quality layer of low particle density and porosity, and also affords good control over layer thickness. The layer 7 shall be deposited to a thickness in the order of some hundred nanometers. A preferred deposition temperature is between 250 and 400°C. Although not shown, one or more additional dielectric layers may be deposited on the structure.

The structure, referenced 8 in Fig. 1, is then patterned and etched with the aid of a conventional photolithographic process, wherein the mutually superimposed additional dielectric layer (not shown) when present, the dielectric layer 7 and the amorphous silicon layer 6 are removed within a predetermined region or area 9 in the etching step. The upper side of the substrate 1 is thus exposed within the region 9. The dielectric layer 7 may be etched with the aid of an anisotropic dry etching process, for instance with the aid of CHF₃/O₂ plasma or C₂F₆ plasma. According to the present invention, the amorphous silicon layer 6 is preferably etched in a dry etching process, which may be anisotropic, e.g. an HBr and/or Cl₂ plasma.

The amorphous silicon, which lacks macroscopic crystal structures, is rich in defects and therefore has greater free energy than polycrystalline and monocrystalline silicon. It is therefore possible to achieve etching selectivity between amorphous silicon and polycrystalline or monocrystalline silicon. The greatest selectivity is obtained with monocrystalline silicon. In this case, it is possible to over-etch such as to positively etch away all amorphous silicon without penetrating the substrate too deeply. When etching amorphous silicon, no undesirable etching is obtained along grain boundaries or crystal surfaces, therewith resulting in smooth etched surfaces. When over-etching into the underlying monocrystalline silicon, a smooth surface is obtained in the absence of replica or facets of the grain structure, so-called reproduction of facet crystal grains or residual crystal grains, so-called pillars, as would possibly be the case when etching polycrystalline or microcrystalline silicon. Furthermore, an opening that is etched out in amorphous silicon will have sharper edges and smoother side walls than a corresponding opening that is etched-out in polycrystalline silicon. It is highly important to achieve good CD control, i.e. control over the dimensions of the etched opening, particularly when fabricating semiconductor devices within the sub-µm range, such control being achieved when etching in amorphous silicon.

The amorphous silicon layer 6 may optionally be doped prior to depositing the protective dielectric layer 7, said doping conveniently being effected by ion implantation. Ion implantation in amorphous silicon avoids channelization of the dopant in grain boundaries and crystal directions, such channelization normally occurring when ion implanting in crystalline silicon. When the layer 6 is doped p+, there is used the gas BF₃, which is ionized and accelerated, wherein desired ions are sorted out and allowed to penetrate into the silicon. The gas used is preferably BF₂⁺ because this ion is produced in large quantities in the ionization process and boron will diffuse to a shallower depth in the substrate in a possible later heat-treatment process. Incorporation of fluorine in the amorphous silicon layer 6 can also contribute towards enabling the natural oxide boundary layer between the amorphous silicon layer 6 and the underlying substrate 1 to be broken-up more easily in a possible later heat-treatment process.

One of the aforedescribed methods can be used conveniently in the fabrication of diodes, metal semiconductor devices, transistors or other types of semiconductor components which include at least one etching step of silicon on silicon.

According to the present invention, the aforedescribed method steps are used as a sub-process in the fabrication of an npn-type bipolar transistor having a self-registered base-emitter structure, for instance.

The method of fabricating a bipolar transistor departs from the structure illustrated in Fig. 2 having defined active regions 2, i.e. as seen from the bottom a p-doped region 2, an n⁺-doped layer 3 for a collector electrode, and nearest the surface an n-doped layer 4, which is surrounded by an electrically insulating region 5.

The window 9 shown in Fig. 2 will form an emitter opening, whereas the amorphous silicon layer 6 will form an extrinsic base.

As shown in Fig. 3, there is then grown on the structure shown in Fig. 2 a thin thermal oxide layer 10 having a thickness of one or more tens of nanometers (Fig. 3) at a temperature which causes the amorphous silicon layer 6 to crystallize. This now crystalline silicon layer is referenced 6' in Fig. 3. A suitable temperature range in this regard is 700-1150°C. Parallel herewith, the dopants are driven into the substrate 1 from the doped, crystalline silicon layer 6' to form a doped area or region 11. A p-doped, intrinsic base 12 is formed by ion implantation of, e.g., BF₂⁺ in the substrate 1 through the medium of the thin oxide layer 10. The p⁺-region 11 enables electric contact to be obtained between the intrinsic base 12 and the extrinsic base 6'.

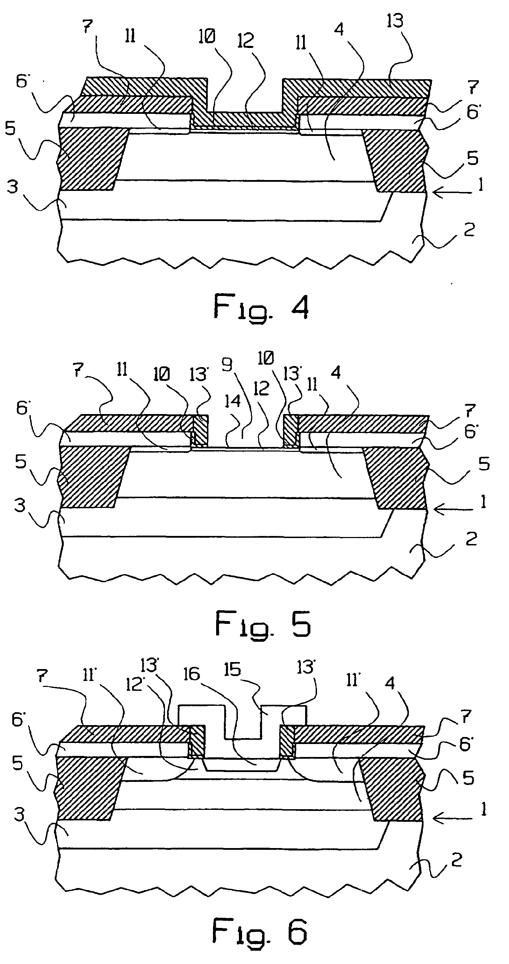

A layer 13 of electrically insulating material is then deposited conformly over the structure according to Fig. 3. The layer 13 will preferably have a thickness of some hundred nanometers and will preferably consist of a nitride, for instance silicon nitride Si₃N₄, and be deposited with the aid of LPCVD technique (Low Pressure Chemical Vapor Deposition). The resultant structure is shown in Fig. 4.

The nitride layer 13 is re-etched anisotropically in a plasma etching process until a thin oxide layer (not shown) remains on top of the substrate 1 in the emitter opening 9. A nitride string or so-called nitride spacer 13' remains along the side walls of the emitter opening 9. This oxide layer (not shown) is then removed by a selective plasma etching process or a wet etching process, therewith exposing the substrate surface 14 in the emitter opening 9. The resultant structure is shown in Fig. 5. This structure is then dipped, optionally in an HF bath or in HF vapour, to remove surface oxide, whereafter an emitter layer (not shown) of polycrystalline or amorphous silicon is deposited on the structure shown in Fig. 5. The emitter layer is deposited preferably to a thickness of some hundred nanometers and is n⁺-doped by implanting arsenic, for instance. The structure is then heat-treated, wherein the dopant (arsenic) is driven into the substrate 1 and forms an n⁺-doped region 16. During the heat-treatment process, boron diffuses down in the substrate, wherewith the intrinsic base and the p⁺⁻doped region become deeper, as evident from the regions referenced 12' and 11' respectively in Fig. 6. A very shallow emitter (n⁺)-base(p)-junction can be obtained by carrying out the method steps with precision and by carefully controlling the steps. The emitter layer (not shown) is patterned lithographically and plasma etched in a conventional manner to define an emitter 15 in the emitter opening 9, as shown in Fig. 6.

Alternatively, the emitter 15 can be grown epitaxially and doped at the same time as it is grown. No patterning or etching of the emitter is necessary when using selective epitaxy. The spacer 13' isolates the extrinsic base 6' electrically from the emitter 15 in both of these cases.

A further oxide layer is then optionally deposited on the structure shown in Fig. 6, whereafter the structure is patterned and etched to form contact holes.

It will be understood that the aforedescribed method can also be used in the fabrication of pnp-transistors, after changing the dopants. In this regard, the amorphous silicon layer 6 and the intrinsic base 12 are preferably doped with PH₃ or AsH₃, whereas the collector 3, 4 and the emitter 15, 16 are doped with BF₃.

The advantages that are afforded by a method of the aforedescribed kind include greater precision in manufacture, the possibility of reducing dimensions, meaning lower base-collector capacitance and lower base resistance of the transistor, and the avoidance of the risk of poor or no electrical contact between intrinsic and extrinsic bases, by virtue of the fact that it is unnecessary to etch out the emitter opening with a powerful over-etching procedure.

It will be understood that the aforedescribed embodiments of the inventive method can also be implemented with other semiconductor materials than silicon. For instance, an amorphous germanium layer can be etched from a crystalline layer of the same material, i.e. germanium, while retaining the aforedescribed advantages.

## Claims

1. A method of etching selectively in the fabrication of a semiconductor device, comprising the steps of;
- depositing an amorphous layer (6) of semiconductor material directly on a crystalline substrate (1) of the same semiconductor material;
- depositing at least one dielectric layer (7) with the aid of either a PECVD, SACVD, MBE technique or a spin-on technique on the amorphous layer (6) without causing crystallization of said amorphous layer (6); and
- with the aid of a photolithographic process patterning and etching the resultant structure (8) to remove the dielectric layer (7) and the amorphous semiconductor layer (6) within a predetermined area or region (9).

2. A method according to Claim 1, **characterized by** forming the dielectric layer (7) from PETEOS.

3. A method according to Claim 1 or 2, **characterized by** depositing the amorphous layer (6) on the substrate (1) with the aid of a CVD technique.

4. A method according to any one of Claims 1-3, **characterized by** depositing the dielectric layer (7) at a temperature of between 250 and 400°C.

5. A method according to any one of Claims 1-4, **characterized by** using silicon as the semiconductor material.

6. A method according to Claim 5, **characterized in that** said semiconductor device is a bipolar transistor having a self-registered base-emitter structure, and **in that** the substrate (1) has an upper region (3 - 4) of a first conductivity type, wherein the method comprises the steps:
- doping the amorphous silicon layer (6) with a dopant of the second conductivity type;
- performing the etching step to define an emitter opening (9);
- growing a thermal oxide (10) on the resultant structure,
wherein the amorphous silicon layer (6) is converted to a polycrystalline silicon layer (6');
- forming an intrinsic base (12) of the same conductivity type as said polycrystalline layer (6') by doping through the thermal oxide (10);
- depositing a layer (13) of electrically insulating material on the resultant structure and thereafter etching the structure anisotropically until a spacer (13') of said electrically insulating material remains along the side walls of the emitter opening (9) and a thin oxide layer remains on the substrate in the emitter opening (9);
- removing said thin oxide layer;
- forming an emitter contact (15) in the emitter opening (9) and doping said emitter contact to said first conductivity type; and
- heat-treating the structure to form an emitter-base junction (16, 12') in the substrate by out diffusion of the dopants from the emitter contact (15).

7. A method according to Claim 6, **characterized by** forming the emitter contact (15) by depositing a layer of polycrystalline silicon and doping said layer to said first conductivity type, and thereafter patterning the doped layer lithographically and plasma-etching said layer.

8. A method according to Claim 6 or 7, **characterized by** doping the amorphous silicon layer (6) by BF₃ ion implantation.

9. A method according to any one of Claims 6-8, **characterized by** forming the spacer (13') from an electrically insulating nitride material (13) and depositing said layer to a thickness of some hundred nanometers with the aid of an LPCVD technique.

## Patentansprüche

1. Verfahren zum selektiven Ätzen bei der Herstellung einer Halbleitereinheit, welches die folgenden Schritte umfasst:
- Aufbringen einer amorphen Schicht (6) eines Halbleitermaterials direkt auf einem kristallinen Substrat (1) desselben Halbleitermaterials;
- Aufbringen mindestens einer Nichtleiterschicht (7) mit Hilfe entweder einer PECVD-, SACVD-, MBE-Technik oder einer Aufschleudertechnik auf die amorphe Schicht (6), ohne die Kristallisation der amorphen Schicht (6) zu verursachen;
- Strukturieren und Ätzen der resultierenden Struktur (8) mit Hilfe eines photolithographischen Verfahrens, um die dielektrische Schicht (7) und die amorphe Halbleiterschicht (6) innerhalb einer vorbestimmten Fläche oder eines Bereiches (9) zu entfernen.

2. Verfahren nach Anspruch 1, **dadurch gekennzeichnet, dass** die dielektrische Schicht (7) aus PETEOS gebildet wird.

3. Verfahren nach Anspruch 1 oder 2, **dadurch gekennzeichnet, dass** die amorphe Schicht (6) auf dem Substrat (1) mit Hilfe einer CVD-Technik aufgebracht wird.

4. Verfahren nach einem der Ansprüche 1 bis 3, **dadurch gekennzeichnet, dass** die dielektrische Schicht (7) bei einer Temperatur zwischen 250 °C und 400 °C aufgebracht wird.

5. Verfahren nach einem der Ansprüche 1 bis 4, **dadurch gekennzeichnet, dass** Silizium als Halbleitermaterial verwendet wird.

6. Verfahren nach Anspruch 5, **dadurch gekennzeichnet, dass** die Halbleitereinheit ein bipolarer Transistor mit einer selbstregistrierenden Basis-Emitter-Struktur ist, und dass das Substrat (1) einen oberen Bereich (3 bis 4) eines ersten Leitfähigkeitstyps aufweist, wobei das Verfahren die folgenden Schritte umfasst:
- Dotieren der amorphen Siliziumschicht (6) mit einem Dotierstoff des zweiten Leitfähigkeitstyps;
- Durchführen des Ätzschrittes, um eine Emitteröffnung (9) zu bilden;
- Wachsen eines thermischen Oxides (10) auf der resultierenden Struktur, wobei die amorphe Siliziumschicht (6) in eine polykristalline Siliziumschicht (6') umgewandelt wird;
- Bilden einer intrinsischen Basis (12) desselben Leitfähigkeitstyps wie die polykristalline Schicht (6') durch Dotieren durch das thermische Oxid (10) hindurch;
- Aufbringen einer Schicht (13) eines elektrisch isolierenden Materials auf der resultierenden Struktur, und danach anisotropes Ätzen der Struktur, bis entlang der Seitenwände der Emitteröffnung (9) ein Abstandhalter (13') des elektrisch isolierenden Materials verbleibt und auf dem Substrat in der Emitteröffnung (9) eine dünne Oxidschicht verbleibt;
- Entfernen der dünnen Oxidschicht;
- Bilden eines Emitterkontaktes (15) in der Emitteröffnung (9) und Dotieren des Emitterkontaktes zu dem ersten Leitfähigkeitstyp; und
- Wärmebehandeln der Struktur, um durch Herausdiffundieren der Dotierstoffe aus dem Emitterkontakt (15) in dem Substrat eine Emitter-BasisVerbindung (16, 12') zu bilden.

7. Verfahren nach Anspruch 6, **dadurch gekennzeichnet, dass** der Emitterkontakt (15) gebildet wird durch Aufbringen einer Schicht polykristallinen Siliziums und durch Dotieren der Schicht zu dem ersten Leitfähigkeitstyp und durch das folgende lithographische Strukturieren der dotierten Schicht und Plasma-Ätzen der Schicht.

8. Verfahren nach Anspruch 6 oder 7, **dadurch gekennzeichnet, dass** die amorphe Siliziumschicht (6) durch BF₃₋Ionenimplantation dotiert wird.

9. Verfahren nach einem der Ansprüche 6 bis 8, **dadurch gekennzeichnet, dass** der Abstandhalter (13') aus einem elektrisch isolierenden Nitridmaterial (13) gebildet wird, und dass die Schicht mit Hilfe einer LPCVD-Technik zu einer Dicke von einigen hundert Nanometern aufgebracht wird.

## Revendications

1. Procédé de gravure sélective au cours de la fabrication d'un dispositif à semiconducteur, comprenant les étapes consistant à :
- déposer une couche amorphe (6) de matériau semiconducteur directement sur un substrat cristallin (1) du même matériau semiconducteur,
- déposer au moins une couche de diélectrique (7) à l'aide d'une technique soit de dépôt PECVD (pour "Plasma Enhanced Chemical Vapor Deposition" - dépôt chimique en phase vapeur renforcé par plasma), de dépôt SACVD (pour "Sub Atmospheric Chemical Vapor Deposition" - dépôt chimique en phase vapeur sous-atmosphérique), par faisceau MBE (pour "Molecular Beam Epitaxy" - épitaxie à faisceau moléculaire), ou une technique de dépôt à la tournette sur la couche amorphe (6) sans provoquer de cristallisation de ladite couche amorphe (6) ; et
- à l'aide d'un processus de photolithographie, réaliser un motif et graver la structure résultante (8) pour éliminer la couche de diélectrique (7) et la couche de semiconducteur amorphe (6) à l'intérieur d'une zone ou d'une région prédéterminée (9).

2. Procédé selon la revendication 1, **caractérisé par** la formation de la couche de diélectrique (7) à partir de PETEOS (pour "Plasma Enhanced Tetra Ethyl Ortho Silicate" - tétraéthylorthosilicate renforcé par plasma).

3. Procédé selon la revendication 1 ou 2, **caractérisé par** le dépôt de la couche amorphe (6) sur le substrat (1) à l'aide d'une technique de dépôt CVD (pour "Chemical Vapor Deposition" - dépôt chimique en phase vapeur).

4. Procédé selon l'une quelconque des revendications 1 à 3, **caractérisé par** le dépôt de la couche de diélectrique (7) à une température entre 250 et 400 °C.

5. Procédé selon l'une quelconque des revendications 1 à 4, **caractérisé par** l'utilisation du silicium comme matériau de semiconducteur.

6. Procédé selon la revendication 5, **caractérisé en ce que** ledit dispositif de semiconducteur est un transistor bipolaire comportant une structure base-émetteur auto-alignée, et **en ce que** le substrat (1) comporte une région supérieure (3 - 4) d'un premier type de conductivité, dans lequel le procédé comprend les étapes consistant à :
- doper la couche de silicium amorphe (6) avec un dopant du second type de conductivité,
- exécuter l'étape de gravure de façon à définir une ouverture d'émetteur (9),
- faire croître un oxyde thermique (10) sur la structure résultante, où la couche de silicium amorphe (6) est convertie en une couche de silicium polycristallin (6'),
- former une base intrinsèque (12) du même type de conductivité que ladite couche polycristalline (6') par dopage au travers de l'oxyde thermique (10),
- déposer une couche (13) de matériau électriquement isolant sur la structure résultante et graver après cela la structure de façon anisotrope jusqu'à ce qu'un élément d'espacement (13') dudit matériau électriquement isolant subsiste le long des parois latérales de l'ouverture d'émetteur (9), et qu'une mince couche d'oxyde subsiste sur le substrat dans l'ouverture d'émetteur (9),
- éliminer ladite mince couche d'oxyde,
- former un contact d'émetteur (15) dans l'ouverture d'émetteur (9) et doper ledit contact d'émetteur pour ledit premier type de conductivité, et
- traiter à chaud la structure pour former une jonction émetteur-base (16, 12') dans le substrat par diffusion des dopants depuis le contact d'émetteur (15).

7. Procédé selon la revendication 6, **caractérisé par** la formation du contact d'émetteur (15) en déposant une couche de silicium polycristallin et en dopant ladite couche pour ledit premier type de conductivité, et en mettant, après cela, en motif la couche dopée par lithographie et en gravant au plasma ladite couche.

8. Procédé selon la revendication 6 ou 7, **caractérisé par** le dopage de la couche de silicium amorphe (6) par implantation d'ions BF₃.

9. Procédé selon l'une quelconque des revendications 6 à 8, **caractérisé par** la formation de l'élément d'espacement (13') à partir d'un matériau de nitrure électriquement isolant (13) et le dépôt de ladite couche à une épaisseur de quelques centaines de nanomètres à l'aide d'une technique de dépôt LPCVD (pour "Low Pressure Chemical Vapor Deposition" - dépôt chimique en phase vapeur à basse pression).
